# EUROPEAN PATENT APPLICATION

(11) **EP 4 811 969 A1**
(43) Date of publication of application: **23.09.2026**
(21) Application number: 25212117.3
(22) Date of filing: 29.10.2025
(51) Int. Cl.: H10F 19/90

(54) **PHOTOVOLTAIC MODULE**

(30) Priority: 21.03.2025 CN 202510344236
(71) Applicant: Jinko Solar (Shangrao) Co., Ltd, Shangrao, Jiangxi (CN); Jinko Solar (Haining) Co., Ltd., Haining City, Zhejiang 314415 (CN)
(72) Inventor: WANG, Luchuang, SHANGRAO (CN); PENG, Yingying, SHANGRAO (CN); ZHANG, Ningbo, SHANGRAO (CN); WAN, Hui, SHANGRAO (CN); HU, Yuanhong, SHANGRAO (CN)
(74) Representative: DREISS Patentanwälte PartG mbB

(57) **Abstract**

Provided is a photovoltaic module including adhesive dots, solar cells and solder strips. Adjacent solar cells are connected by the solder strips. The adhesive dots are used to adhere the solder strips to the solar cells. A first side of the solar cell has a first connection region and a second connection region. A second side has a third connection region and a fourth connection region. The first and third connection regions are located at opposite ends of the solar cell. The first connection region is connected to the adjacent third connection region through the solder strip. Each of the first and third connection regions is provided with at least five first adhesive dots. Each of the second and fourth connection regions is provided with a second adhesive dot, so as to improve stability of connection between solder strips and solar cells, improving the quality of solar cells.

## Description

### TECHNICAL FIELD

The present disclosure relates to the field of photovoltaics and, in particular, to a photovoltaic module.

### BACKGROUND

With the development of technology, photovoltaic modules have become a commonly used device. The photovoltaic module includes a plurality of solar cells, with adjacent solar cells connected by solder strips. The stability of the connection between the solder strip and the solar cell is poor, and the tensile force that can be withstood is relatively small. During use, problems such as desoldering and cold soldering are likely to occur, which affects the quality of the photovoltaic module.

### SUMMARY

One or more embodiments of the present disclosure provides a photovoltaic module for improving the stability of the connection between a solder strip and a solar cell.

One or more embodiments of the present disclosure provides a photovoltaic module, including: a plurality of solar cells, a plurality of solder strips, and adhesive dots. At least two of the solar cells are arranged along a length direction of the photovoltaic module. The solder strips are used to connect adjacent solar cells along the length direction of the photovoltaic module. The adhesive dots are used to adhere the solder strips to the solar cells. Along a thickness direction of the solar cells, each solar cell of the solar cells includes a first side and a second side. The first side is provided with a first connection region and a second connection region, and the second side is provided with a third connection region and a fourth connection region. Along a length direction of the solar cells, the first connection region and the third connection region are located at opposite ends of the solar cell, and the first connection region of the solar cell is connected to the third connection region of the adjacent solar cell through the solder strip. The adhesive dots include first adhesive dots and second adhesive dots. The first connection region and the third connection region are respectively provided with at least five first adhesive dots, and the second connection region and the fourth connection region are respectively provided with a second adhesive dot.

In one or more embodiments, along the length direction of the photovoltaic module, the distance between the first adhesive dots provided in the same first connection region is 1.5 mm to 2.5 mm, and/or the distance between the first adhesive dots provided in the same third connection region is 1.5 mm to 2.5 mm.

In one or more embodiments, the first connection region and the third connection region are respectively provided with six to eight first adhesive dots.

In one or more embodiments, along the length direction of the photovoltaic module, the size of the first adhesive dots is 1.3 mm to 3 mm, and along a width direction of the photovoltaic module, the size of the first adhesive dots is 2 mm to 4 mm.

In one or more embodiments, the solar cell includes a main body and harpoon structures provided on the main body. Along the length direction of the photovoltaic module, the harpoon structures are provided at opposite ends of the main body, respectively. Each of the harpoon structures includes a soldering member, and the solder strip is provided on the main body through the soldering member. The first connection region is located between the second connection region and the soldering member, and the third connection region is located between the fourth connection region and the soldering member. Along the length direction of the photovoltaic module, the length of the first connection region is 14 mm to 55 mm, and the length of the third connection region is 14 mm to 55 mm.

In one or more embodiments, the second connection region and the fourth connection region are respectively provided with two to ten second adhesive dots.

In one or more embodiments, the solder strip includes a first connection segment and a second connection segment. One of the first connection segment and the second connection segment is located in the second connection region of the solar cell, and the other of the first connection segment and the second connection segment is located in the fourth connection region of another solar cell. At the same side of the solar cell, the first connection segment and the second connection segment are arranged spaced apart from each other. The spacing between the second adhesive dots provided in the first connection segment is m, and the spacing between the second adhesive dots provided in the second connection segment is n, where m≠n.

In one or more embodiments, the spacing m between the second adhesive dots provided in the first connection segment satisfies: 20 mm≤m≤32 mm, and the spacing n between the second adhesive dots provided in the second connection segment satisfies: 30 mm ≤n≤38 mm.

In one or more embodiments, along the length direction of the photovoltaic module, the size of the second adhesive dots is 1 mm to 2 mm, and along the width direction of the photovoltaic module, the size of the second adhesive dots is 1.5 mm to 3 mm.

In one or more embodiments, the solar cell includes a plurality of fingers extending along the width direction of the photovoltaic module. The fingers are arranged spaced apart from each other along the length direction of the photovoltaic module. The solder strips are connected to the fingers, and the adhesive dots are provided at intersections between the solder strips and the fingers.

One or more embodiments of the present disclosure provides a photovoltaic module, including adhesive dots, a plurality of solar cells and a plurality of solder strips. Adjacent solar cells are connected by the solder strips, and the adhesive dots are used to adhere the solder strips to the solar cells. A first side of the solar cell has a first connection region and a second connection region, and a second side has a third connection region and a fourth connection region. The first connection region and the third connection region are located at opposite ends of the solar cell, and the first connection region is connected to the adjacent third connection region through the solder strip. The first connection region and the third connection region are respectively provided with at least five first adhesive dots, and the second connection region and the fourth connection region are respectively provided a the second adhesive dot. Such a design can improve the stability of the connection between the solder strips and the solar cells, thereby improving the quality of the solar cells and better meeting practical usage requirements.

### BRIEF DESCRIPTION OF DRAWINGS

In order to better illustrate the technical solutions in embodiments of the present disclosure, the drawings used in the description of embodiments are briefly described as below. It will be apparent that the drawings described below are merely some embodiments of the present disclosure, and other drawings may be obtained by those skilled in the art according to these drawings without paying any creative efforts.
FIG. 1 is a partial schematic diagram of a photovoltaic module according to one or more embodiments of the present disclosure;
FIG. 2 is a partial cross-sectional view of a photovoltaic module according to one or more embodiments of the present disclosure;
FIG. 3 is a partial enlarged view of position I in FIG. 1;
FIG. 4 is a schematic diagram of a solar cell according to one or more embodiments of the present disclosure; and
FIG. 5 is a schematic diagram of a paste-printing screen according to one or more embodiments of the present disclosure.

### Reference signs:

1 - solar cell;
   11 - first side;
      111- first connection region;
      112- second connection region;
   12- second side;
      121- third connection region;
      122- fourth connection region;
   13- main body;
   14- harpoon structure;
      141- soldering member;
   15- finger;
2-solder strip;
   21- first connection segment;
   22- second connection segment;
3- adhesive dot;
   31- first adhesive dot;
   32- second adhesive dot;
4- paste-printing screen.

### DESCRIPTION OF EMBODIMENTS

In order to better understand the technical solutions of the present disclosure, embodiments of the present disclosure are described in detail below in conjunction with the drawings.

It should be noted that, the described embodiments are only some rather than all of embodiments of the present disclosure. All other embodiments obtained by those skilled in the art without creative efforts according to embodiments of the present disclosure are within the protection scope of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used herein is merely an association relationship describing an associated object, indicating that there may be three relationships, for example, A and/or B, and may indicate: only A, both A and B, and only B. In addition, the character "/" herein generally indicates that the related objects prior to and subsequent to the character present an "or" relationship.

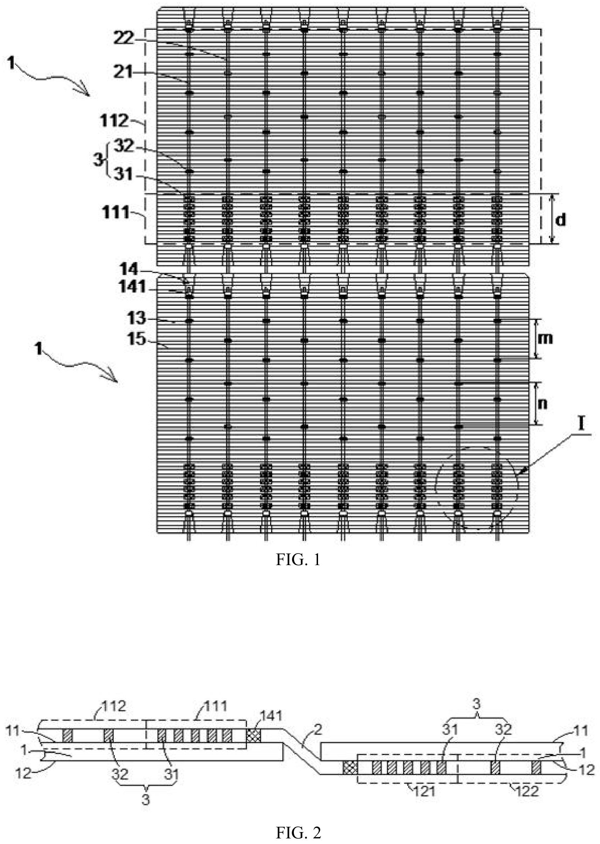

As shown in FIG. 1, one or more embodiments of the present disclosure provides a photovoltaic module, including a plurality of solar cells 1 and a plurality of solder strips 2. At least two solar cells 1 are arranged along the length direction of the photovoltaic module, and adjacent solar cells 1 are connected by the solder strip 2 to form a solar cell string. At least two solar cell strings are arranged along the width direction of the photovoltaic module to form a solar cell array. The solder strip 2 can be adhered to the solar cell 1 through an adhesive dot 3. As shown in FIG. 2, along the thickness direction of the solar cells 1, the solar cell 1 has a first side 11 and a second side 12, the first side 11 of each solar cell 1 is located at the same side of the photovoltaic module, and the second side 12 of each solar cell 1 is located at the same side of the photovoltaic module. The first side 11 is provided with a first connection region 111 and a second connection region 112, and the second side 12 is provided with a third connection region 121 and a fourth connection region 122. Along the length direction of the solar cells 1, the first connection region 111 and the third connection region 121 are located at opposite ends of the solar cell 1. That is, along the length direction of the solar cells 1, the first connection region 111 is provided at one end of the solar cell 1, and the third connection region 121 is provided at the other end thereof. When the solar cells 1 are arranged along the length of the photovoltaic module, the first connection region 111 of the solar cell 1 and the third connection region 121 of the adjacent solar cell 1 are adjacent to each other. The first connection region 111 of the solar cell 1 is connected to the third connection region 121 of the adjacent solar cell 1 through the solder strip 2. The adhesive dots 3 include first adhesive dots 31 and second adhesive dots 32. The first adhesive dot 31 is provided in the first connection region 111 and the third connection region 121, and the second adhesive dot 32 is provided in the second connection region 112 and the fourth connection region 122. The first connection region 111 is provided with at least five first adhesive dots 31. The third connection region 121 is provided with at least five first adhesive dots 31. The number of the first adhesive dots 31 provided in the first connection region 111 and the third connection region 121 may be 5, 6, 7, 8, 9, 10, 11, 12, etc., respectively.

Generally, the stability of the connection between the solder strip 2 and the solar cell 1 is relatively poor, and the tensile force that can be withstood is relatively small. For example, a busbar-free 0BB solar sell only includes a finger 15, and the connection between the solder strip 2 and the solar cell 1 is merely the connection between the solder strip 2 and the finger 15. The tensile force that can be withstood is relatively small, usually not exceeding 0.5 N. Furthermore, since the solder strip 2 and the solar cell 1 have different coefficients of expansion, electrical connection failures and other issues are likely to occur at the connection position between the solder strip 2 and the solar cell 1 during reliability testing. Furthermore, since the tensile force between the solder strip 2 and the solar cell 1 is relatively small, the solder strip 2 is prone to offset and desoldering during the lamination process of the photovoltaic module, which affects the quality and operating efficiency of the photovoltaic module.

In the solution provided in one or more embodiments of the present disclosure, the solder strip 2 can be adhered to the solar cell 1 by providing adhesive dots 3, thereby improving the stability of the connection between the solder strip 2 and the solar cell 1. The first connection region 111 and the third connection region 121 are located at the sides where the adjacent solar cells 1 are connected to each other. By providing at least five adhesive dots 3 in the first connection region 111 and the third connection region 121, respectively, the stability of the connection between the solder strip 2 and the solar cell 1 can be improved, thereby improving the stability of the connection between the interconnected sides of the solar cells 1. Such a design can reduce the possibility of desoldering or false soldering of the solder strip 2 during testing, thereby facilitating improving the operating stability of the photovoltaic module.

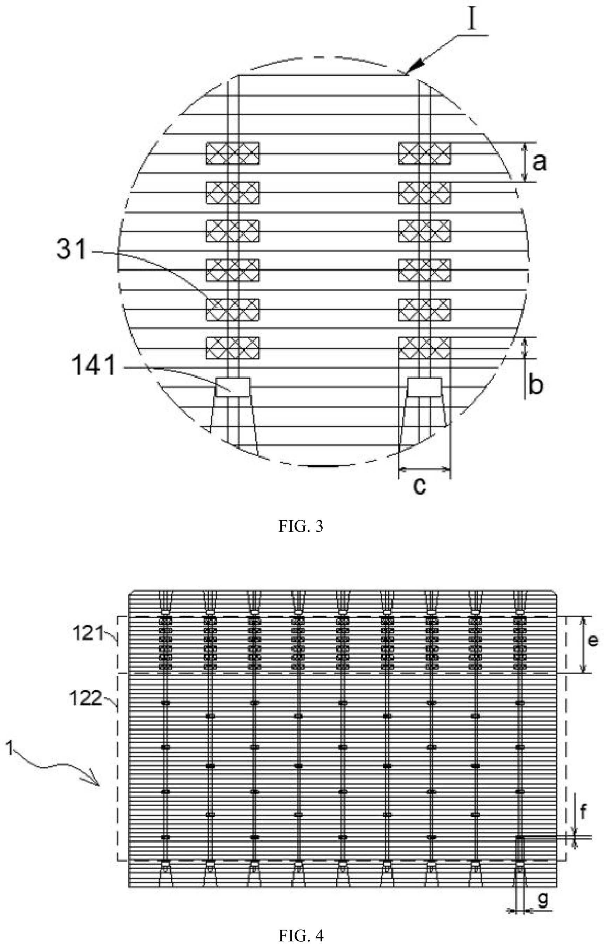

As shown in FIG. 3, in one or more embodiments, along the length direction of the photovoltaic module, the spacing between the first adhesive dots 31 provided in the same first connection region 111 is 1.5 mm to 2.5 mm, and/or the spacing between the first adhesive dots 31 provided in the same third connection region 121 is 1.5 mm to 2.5 mm. That is, the spacing between adjacent first adhesive dots 31 provided in the same connection region is 1.5 mm to 2.5 mm. The spacing between adjacent first adhesive dots 31 may be 1.5 mm, 1.6 mm, 1.7 mm, 1.8 mm, 1.9 mm, 2.0 mm, 2.1 mm, 2.2 mm, 2.3 mm, 2.4 mm, 2.5 mm, etc.

When the spacing between adjacent first adhesive dots 31 is less than 1.5 mm, the spacing between adjacent first adhesive dots 31 is too small. When dispensing adhesive through a paste-printing screen 4, the distance between adjacent meshes is so small that the processing difficulty will increase, and the overall area of the adhesive application region will be reduced, which affects the reinforcing effect of the adhesive dots 3 on the stability of the connection between the solder strips 2. When the distance between adjacent first adhesive dots 31 is greater than 2.5 mm, the spacing between adjacent first adhesive dots 31 is too large, which affects the adhesive application effect. Therefore, in the solution provided in one or more embodiments of the present disclosure, the spacing between adjacent first adhesive dots 31 may be 1.5 mm to 2.5 mm. Such a design not only improves the stability of the connection between the adhesive dot 3 and the solar cell 1, but also reduces the processing difficulty of the paste-printing screen 4, which better meets practical usage requirements.

In one or more embodiments, the first connection region 111 and the second connection region 112 may be provided with six to eight first adhesive dots 31, respectively.

By optimizing the number of the first adhesive dots 31, the number of the first adhesive dots 31 can be reduced as much as possible while meeting the connection strength requirements between the solder strip 2 and the solar cell 1, thereby improving processing efficiency and saving costs.

As shown in FIG. 3, in one or more embodiments, along the length direction of the photovoltaic module, the size of the first adhesive dot 31 is b, where 1.3 mm≤b≤3 mm; and along the width direction of the photovoltaic module, the size of the first adhesive dot 31 is c, where 2 mm≤c≤4 mm. The size b of the first adhesive dot 31 may be 1.3 mm, 1.5 mm, 1.7 mm, 1.9 mm, 2.1 mm, 2.3 mm, 2.5 mm, 2.7 mm, 2.9 mm, 3.0 mm, etc. The size c of the first adhesive dot 31 may be 2.0 mm, 2.2 mm, 2.4 mm, 2.6 mm, 2.8 mm, 3.0 mm, 3.2 mm, 3.4 mm, 3.6 mm, 3.8 mm, 4.0 mm, etc.

When the size of the first adhesive dot 31 is too small, the reinforcing effect of the first adhesive dot 31 on reinforcing the solder strip 2 is relatively small. When the size of the first adhesive dot 31 is too large, the area of adhesive dispensing increases, resulting in an increase in adhesive dispensing amount and costs. Furthermore, the adhesive is more likely to overflow. In addition, an excessively large area of adhesive dispensing prolongs the curing time, which affects production efficiency and increases production cycle.

As shown in FIG. 1, in one or more embodiments, the solar cell 1 may include a main body 13 and harpoon structures 14. The harpoon structures 14 are provided on the main body 13, and the main body 13 may be a processed silicon wafer or the like. Along the length direction of the photovoltaic module, the harpoon structures 14 are provided at opposite ends of the main body 13, and both the first side 11 and the second side 12 are provided with the harpoon structures 14. The harpoon structure 14 includes a soldering member 141. The solder strip 2 may be soldered to the main body 13 through the soldering member 141. The first connection region 111 is located between the second connection region 112 and the soldering member 141. The third connection region 121 is located between the fourth connection region 122 and the soldering member 141. Along the length direction of the photovoltaic module, the length of the first connection region 111 is 14 mm to 55 mm, and the length of the third connection region 121 is 14 mm to 55 mm.

In one or more embodiments, the shape of the first adhesive dot 31 may be approximately rectangular, and the area may be 2.6 mm² to 1.2 mm².

Controlling the area of the first adhesive dot 31 within an appropriate range can improve the stability of the connection between the solder strip 2 and the solar cell 1 while saving costs.

As shown in FIG. 1, FIG. 2 and FIG. 4, the first connection region 111 of one of two adjacent solar cells 1 and the third connection region 121 of the other one of the two adjacent solar cells 1 are located at the ends of the two solar cells 1 that are close to each other, and the second connection region 112 and the fourth connection region 122 are located at the ends of the two solar cells 1 that are far away from each other. Along the length direction of the photovoltaic module, the region along the soldering member 141 at the first side 11 of the solar cell 1, extending toward the interior of the solar cell 1 by 14 mm to 55 mm, is the first connection region 111, and the remaining region at the first side 11 can serve as the second connection region 112. The region along soldering member 141 at the second side 12 of the solar cell 1, extending toward the interior of the solar cell 1 by 14 mm to 55 mm, is the third connection region 121, and the remaining region at the second side 12 can serve as the fourth connection region 122. The lengths of the first connection region 111 and the third connection region 121 may be 14 mm, 16 mm, 18 mm, 20 mm, 22 mm, 24 mm, 26 mm, 28 mm, 30 mm, 32 mm, 34 mm, 36 mm, 38 mm, 40 mm, 42 mm, 44 mm, 46 mm, 48 mm, 50 mm, 52 mm, 54 mm, 55 mm, etc., respectively.

When the lengths of the first connection region 111 and third connection region 121 are less than 14 mm, the sizes of the first connection region 111 and third connection region 121 are too small, and the space for providing the first adhesive dots 31 is too small, which results in a reduced number of the first adhesive dots 31, affects the stability of the adhesion between the solder strip 2 and the solar cell 1, and causes the arrangement of the first adhesive dots 31 to be overly dense, thereby increasing the difficulty of adhesive dispensing. When the lengths of the first connection region 111 and the third connection region 121 are greater than 5.5 mm, the sizes of the first connection region 111 and the third connection regions 121 are too large, which results in an increased spacing between the first adhesive dots 31, and affects the stability of the adhesion between the solder strip 2 and the solar cell 1.

In one or more embodiments, the second connection region 112 and the fourth connection region 122 are provided with two to ten second adhesive dots 32, respectively. The number of the second adhesive dots 32 may be 2, 3, 4, 5, 6, 7, 8, 9, or 10.

When the number of the second adhesive dots 32 is too small, the stability of the adhesion between the solder strip 2 and the solar cell 1 decreases. When the number of the second adhesive dots 32 is too large, the overall adhesive dispensing amount increases, which not only increases costs but also affect processing efficiency. Therefore, the number of the second adhesive dots 32 may generally be two to ten, which can control the production costs while satisfying the stability of the adhesion, and better meets practical usage requirements.

As shown in FIG. 1 and FIG. 2, in one or more embodiments, the solder strip 2 may include a first connection segment 21 and a second connection segment 22 that are connected to each other. One of the first connection segment 21 and the second connection segment 22 is located in the second connection region 112, and the other is located in the fourth connection region 122 of another solar cell 1. The photovoltaic module includes a plurality of solder strips 2. At the same side of the solar cell 1, the first connection segment 21 and the second connection segment 22 are arranged spaced apart from each other. That is, along the arrangement direction of the solder strips 2, the second connection segment 22 of other solder strips 2 are respectively located at both sides of the first connection segment 21, and the first connection segments 21 of other solder strips 2 are respectively located at both sides of the second connection segment 22. The spacing between the second adhesive dots 32 provided in the first connection segment 21 is m, and the spacing between the second adhesive dots 32 provided in the second connection segment 22 is n, where m≠n.

Such a design allows the second adhesive dots 32 of adjacent solder strips 2 to be arranged in a staggered manner, which is beneficial for improving the stability of the connection between the solder strip 2 and the solar cell 1, and reducing the number of the second adhesive dots 32, thereby saving adhesive dispensing amount.

As shown in FIG. 1, in one or more embodiments, the spacing m between the second adhesive dots 32 provided in the first connection segment 21 satisfies: 20 mm≤m≤32 mm, and the spacing n between the second adhesive dots 32 provided in the second connection segment 22 satisfies: 30 mm≤n≤38 mm. The value of m may be 20 mm, 21 mm, 22 mm, 23 mm, 24 mm, 25 mm, 26 mm, 27 mm, 28 mm, 29 mm, 30 mm, 31 mm, 32 mm, etc. The value of n may be 30 mm, 31 mm, 32 mm, 33 mm, 34 mm, 35 mm, 36 mm, 37 mm, 38 mm, etc.

By controlling the spacing between adjacent second adhesive dots 32, the second adhesive dots 32 can be evenly distributed on the solder strip 2, thereby improving the stability of the connection between the solder strip 2 and the solar cell 1.

The first connection segment 21 and the second connection segment 22 of the same solder strip 2 can be respectively connected to different solar cells 1. Since the spacing between the second adhesive dots 32 provided in the second connection segment 22 is relatively large, the number of the second adhesive dots 32 provided in the second connection segment 22 can be less than the number of the second adhesive dots 32 provided in the first connection segment 21, thereby reducing the overall adhesive dispensing amount and saving costs.

In one or more embodiments, the first connection segment 21 of one of the solder strips 2 is arranged in the second connection region 112 of the preceding solar cell 1, and the second connection segment 22 is arranged in the fourth connection region 122 of the subsequent solar cell 1. The solder strip 2 adjacent to this solder strip 2 is arranged in such a manner that the second connection segment 22 is located in the second connection region 112 of the preceding solar cell 1 and the first connection segment 21 is located in the fourth connection region 122 of the subsequent solar cell 1.

Such arrangement can balance the stability of the connection between the solder strip 2 and the adjacent solar cell 1, thereby reducing the possibility of desoldering between the solder strip 2 and the solar cell 1.

As shown in FIG. 4, in one or more embodiments, along the length direction of the photovoltaic module, the size of the second adhesive dot 32 is f, where 1 mm≤f≤2 mm; along the width direction of the photovoltaic module, the size of the second adhesive dot 32 is g, where 1.5 mm≤g≤3 mm; f may be 1.0 mm, 1.1 mm, 1.2 mm, 1.3 mm, 1.4 mm, 1.5 mm, 1.6 mm, 1.7 mm, 1.8 mm, 1.9 mm, 2.0 mm, etc.; and g may be 1.5 mm, 1.7 mm, 1.9 mm, 2.1 mm, 2.3 mm, 2.5 mm, 2.7 mm, 2.9 mm, 3.0 mm, etc.

When the size of the second adhesive dot 32 is too small, the adhesive ability of the second adhesive dot 32 decreases, thereby affecting the stability of the adhesion between the solder strip 2 and the solar cell 1. When the size of the second adhesive dot 32 is too large, the adhesive dispensing amount increases, thereby increasing the costs.

In one or more embodiments, the solar cell 1 includes a plurality of fingers 15, and the fingers 15 can be provided on the main body 13 of the solar cell 1. The fingers 15 extend along the width direction of the photovoltaic module, and are arranged spaced apart from each other along the length direction of the photovoltaic module. The solder strips 2 extend along the length direction of the photovoltaic module, and are arranged along the width direction of the photovoltaic module. The solder strips 2 are connected to the fingers 15, and the adhesive dots 3 are provided at the intersections of the solder strips 2 and the fingers 15.

The finger 15 is used to collect the photocurrent generated by the solar cell 1. The solder strip 2 can be connected to the finger 15 to lead out the current collected by the finger 15. By providing adhesive dots 3 at the connection position between the solder strip 2 and the finger 15, the stability of the connection between the solder strip 2 and the finger 15 can be improved, thereby facilitating the solder strip 2 to collect the current from the finger 15, and improving the overall quality and efficiency of the photovoltaic module.

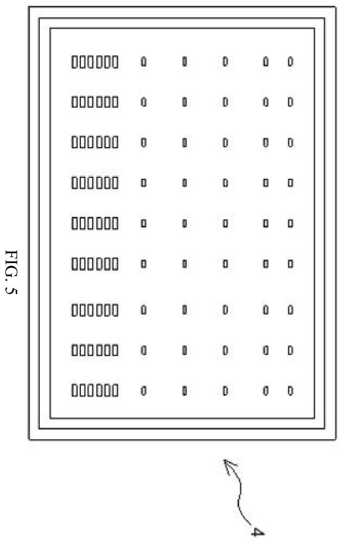

During the production of the photovoltaic module, the structure of the paste-printing screen 4 may be as shown in FIG. 5. Adhesive dispensing holes are provided on the paste-printing screen 4 according to the positions of the adhesive dots 3. The paste-printing screen 4 can be provided with a dense adhesive dispensing region and a staggered adhesive dispensing region. The dense adhesive dispensing region can correspond to the first connection region 111 and the third connection region 121 of the solar cell 1, and is used to provide the first adhesive dots 31. The staggered adhesive dispensing region can correspond to the second connection region 112 and the fourth connection region 122 of the solar cell 1, and is configured to provide the second adhesive dots 32.

In the solution provided in one or more embodiments of the present disclosure, by providing at least five first adhesive dots 31 at the interconnected sides of adjacent solar cells 1, respectively, the stability of the connection between the solder strip 2 and the solar cell 1 can be improved, thereby reducing the occurrence of desoldering or false soldering of the solder strip 2, and facilitating improving the quality of the photovoltaic module.

In one or more embodiments, the solar cell 1 of the photovoltaic module according to one or more embodiments of the present disclosure may be a passivated emitter rear cell (PERC), a tunnel oxide passivated contact (TOPCon) cell, a heterojunction with intrinsic thin-film (HJT) cell, an interdigitated back contact (IBC) cell, etc. The solar cell 1 may be a solar cell 1 with a busbar or a busbar-free solar cell 1.

During production, different process flows can be selected according to the requirements. For example, the solder strips 2 can be arranged first before dispensing the adhesive, or the adhesive can be dispensed first before arranging the solder strips 2.

In one or more embodiments, a plurality of solar cells 1 may be arranged along a first direction, where the first direction may correspond to the length direction of the photovoltaic module. The solder strip 2 is connected to the corresponding solar cell 1. Pre-soldering is performed on the solder strip 2 and the solar cell 1, so that the solder strip 2 and the solar cell 1 are relatively fixedly connected. The solder strip 2 and the solar cell 1 may be used to form a solar cell string, and the solar cell string is provided in the paste-printing device. The paste-printing screen 4 is placed on the solar cell string. The paste-printing screen 4 is provided with meshes, and the position of each mesh corresponds to the position of the adhesive dot 3. The adhesive is applied onto the paste-printing screen 4, and the adhesive is scraped into the meshes by a scraper of the paste-printing device, so that the adhesive contacts the solder strip 2 and the solar cell 1. The solar cell string, after adhesive dispensing is completed, is then transferred to a curing device for curing.

In one or more embodiments, the adhesive can first be dispensed to the solar cells 1. The solar cells 1 are placed in the paste-printing device, with the paste-printing screen 4 arranged corresponding to each solar cell 1. The adhesive is applied onto the paste-printing screen 4 and scraped into the meshes by the scraper, so that the adhesive contacts the solar cells 1 to form the adhesive dots. The solar cells 1 with adhesive dots are removed from the paste-printing device, and the solar cells 1 are arranged along the first direction which may correspond to the length direction of the photovoltaic module. Adjacent solar cells 1 are connected and soldered through the solder strips 2. The solar cells 1 and the solder strips 2 are used to form the solar cell string. The solar cell string is placed in the curing device for curing.

The solar cell strings obtained by first providing the solder strips 2 and then providing the adhesive dots 3, and by first providing the adhesive dots 3 and then providing the solder strips 2, have approximately the same performance and achieve the same technical effect.

The obtained solar cell strings are arranged along a second direction, where the second direction may be the same as the width direction of the photovoltaic module. According to the requirements of the photovoltaic module, a certain number of the solar cells 1 are connected to form a solar cell string, and a certain number of the solar cell strings are then arranged to form a solar cell array. The photovoltaic module may further include a first cover plate, a first adhesive film, a second cover plate, and a second adhesive film. The first adhesive film and the second adhesive film are located at opposite sides of the solar cell array along the thickness direction of the photovoltaic module, the first cover plate is located at the side of the first adhesive film away from the solar cell array, and the second cover plate is located at the side of the second adhesive film away from the solar cell array.

In one or more embodiments, the first cover plate can be located at the light-receiving side of the photovoltaic module, and the second cover plate can be located at the backlight side of the photovoltaic module. The first cover plate may be a light-transmitting structure, such as glass. The second cover plate may be a reflective structure or made of a reflective material. Light passes through the first cover plate and the first adhesive film before reaching the solar cell array. The solar cell 1 absorbs light and generates photocurrent. The finger 15 is used to collect the photocurrent. The solder strip 2 is used to lead out the photocurrent of the electrode line. Light that is not absorbed by the solar cell 1 passes through the solar cell 1 and the second adhesive film to reach the second cover plate. The second cover plate can reflect the light toward the direction of the solar cell array, so that the solar cell array can absorb the light again, thereby improving the absorption efficiency of the solar cell, and facilitating improving the overall efficiency of the photovoltaic module.

In one or more embodiments, two sides of the photovoltaic module are light-receiving sides, and the first cover plate and the second cover plate are light-transmitting structures. During use, both opposite sides of the photovoltaic module can be used to absorb light, thereby facilitating improving the efficiency of the photovoltaic module.

The first adhesive film and the second adhesive film can, to a certain extent, serve to connect the cover plates and the solar cells 1. Also, the first adhesive film and the second adhesive film can provide cushioning and shock-absorption effects. When the photovoltaic module is subjected to impact, the first adhesive film and the second adhesive film can provide cushioning, thereby reducing the likelihood of cracks or breakage in the solar cells 1, and facilitating improving the service life of the photovoltaic module and better meeting practical usage requirements.

One or more embodiments of the present disclosure provides a photovoltaic module, including adhesive dots 3, a plurality of solar cells 1, and a plurality of solder strips 2. Adjacent solar cells 1 are connected by the solder strips 2, and the adhesive dots 3 are used to adhere the solder strips 2 to the solar cells 1. A first side 11 of the solar cell 1 has a first connection region 111 and a second connection region 112, and a second side 12 has a third connection region 121 and a fourth connection region 122. The first connection region 111 and the third connection region 121 are located at opposite ends of the solar cell 1, and the first connection region 111 is connected to the adjacent third connection region 121 through the solder strip 2. The first connection region 111 and the third connection region 121 are respectively provided with at least five first adhesive dots 31, and the second connection region 112 and the fourth connection region 122 are respectively provided with a second adhesive dot 32. Such a design can improve the stability of the connection between the solder strips 2 and the solar cells 1, thereby improving the quality of the solar cells 1 and better meeting practical usage requirements.

The structure, features and functional effects of the present disclosure are described in detail by the above embodiments illustrated with reference to the drawings. The above description is only preferred embodiments of the present disclosure, but the scope of implementation of the present disclosure is not limited by the drawings. Any modification made in accordance with the concept of the present disclosure, or equivalent embodiments formed by equivalent variations, shall fall within the protection scope of the present disclosure, as long as they do not depart from the spirit encompassed by the specification and the drawings.

## Claims

1. A photovoltaic module, comprising:
a plurality of solar cells, wherein at least two of the plurality of the solar cells are arranged along a length direction of the photovoltaic module;
a plurality of solder strips configured to connect adjacent solar cells along the length direction of the photovoltaic module; and
a plurality of adhesive dots configured to adhere the solder strips to the solar cells;
wherein along a thickness direction of the solar cells, at least one solar cell comprises a first side and a second side, the first side is provided with a first connection region and a second connection region, the second side is provided with a third connection region and a fourth connection region, along a length direction of the solar cells, the first connection region and the third connection region are located at opposite ends of the solar cell, the first connection region of the at least one solar cell is connected to the third connection region of an adjacent solar cell through at least one solder strip, the adhesive dots comprise first adhesive dots and second adhesive dots, each of the first connection region and the third connection region is provided with at least five first adhesive dots, and each of the second connection region and the fourth connection region is provided with at least one second adhesive dot.

2. The photovoltaic module according to claim 1, wherein along the length direction of the photovoltaic module, distances between the first adhesive dots located in a same first connection region are within a range of 1.5 mm to 2.5 mm, and/or distances between the first adhesive dots located in a same third connection region are within a range of 1.5 mm to 2.5 mm.

3. The photovoltaic module according to claim 1, wherein each of the first connection region and the third connection region is provided with six to eight first adhesive dots.

4. The photovoltaic module according to claim 1, wherein along the length direction of the photovoltaic module, dimensions of the first adhesive dots are within a range of 1.3 mm to 3 mm, and along a width direction of the photovoltaic module, dimensions of the first adhesive dots are within a range of 2 mm to 4 mm.

5. The photovoltaic module according to claim 1, wherein
at least one solar cell comprises a main body and harpoon structures provided on the main body, the harpoon structures are arranged at opposite ends of the main body, respectively, along the length direction of the photovoltaic module, each of the harpoon structures comprises a soldering member, at least one solder strip is provided on the main body through the soldering member, the first connection region is located between the second connection region and the soldering member, and the third connection region is located between the fourth connection region and the soldering member; and
along the length direction of the photovoltaic module, a length of the first connection region is within a range of 14 mm to 55 mm, and a length of the third connection region is within a range of 14 mm to 55 mm.

6. The photovoltaic module according to any one of claims 1 to 5, wherein each of the second connection region and the fourth connection region is provided with two to ten second adhesive dots.

7. The photovoltaic module according to claim 6, wherein
at least one solder strip comprises a first connection segment and a second connection segment, one of the first connection segment and the second connection segment is located in the second connection region of the at least one solar cell, and the other of the first connection segment and the second connection segment is located in the fourth connection region of another solar cell, and at a same side of the at least one solar cell, the first connection segment and the second connection segment are arranged spaced apart from each other; and
a spacing between the second adhesive dots provided in the first connection segment is m, and a spacing between the second adhesive dots provided in the second connection segment is n, wherein m≠n.

8. The photovoltaic module according to claim 7, wherein the spacing m between the second adhesive dots provided in the first connection segment satisfies: 20 mm≤m≤32 mm, and the spacing n between the second adhesive dots provided in the second connection segment satisfies: 30 mm ≤n≤38 mm.

9. The photovoltaic module according to any one of claims 1 to 5, wherein along the length direction of the photovoltaic module, dimensions of the second adhesive dots are within a range of 1 mm to 2 mm, and along a width direction of the photovoltaic module, dimensions of the second adhesive dots are within a range of 1.5 mm to 3 mm.

10. The photovoltaic module according to any one of claims 1 to 5, wherein at least one solar cell comprises a plurality of fingers extending along a width direction of the photovoltaic module, the plurality of fingers are arranged spaced apart from one another along the length direction of the photovoltaic module, the solder strips are connected to the fingers, and the adhesive dots are provided at intersections between the solder strips and the fingers.

11. The photovoltaic module according to claim 1, wherein the first connection region and the third connection region are located at sides of adjacent solar cells where the adjacent solar cells are connected to each other.

12. The photovoltaic module according to claim 1, wherein a first connection region of one of two adjacent solar cells and a third connection region of the other one of the two adjacent solar cells are located at ends of the two adjacent solar cells that are close to each other, and second connection regions and fourth connection regions of the two adjacent solar cells are located at ends of the adjacent two solar cells that are away from each other.

13. The photovoltaic module according to claim 7, wherein a first connection segment and a second connection segment of a same solder strip is respectively connected to different solar cells.

14. The photovoltaic module according to claim 13, wherein a number of the second adhesive dots provided in the second connection segment is less than a number of the second adhesive dots provided in the first connection segment.

15. The photovoltaic module according to claim 1, wherein the photovoltaic module according to claim 1, wherein along the length direction of the photovoltaic module, a dimension of the first adhesive dot is b, wherein 1.3 mm≤b≤3 mm.
